# EUROPEAN PATENT SPECIFICATION

(11) **EP 0 375 209 B1**
(45) Date of publication and mention of the grant of the patent: **26.10.1994**
(21) Application number: 89312759.7
(22) Date of filing: 07.12.1989
(51) Int. Cl.: H01L 21/00

(54) **Semiconductor wafer pick-up device**
Vorrichtung zum Aufheben eines Halbleiterplättchens
Dispositif pour lever une plaquette semi-conductrice

(30) Priority: 20.12.1988 US 286916; 20.12.1988 US 287367
(43) Date of publication of application: 27.06.1990
(73) Proprietor: TEXAS INSTRUMENTS INCORPORATED, Dallas Texas 75265 (US)
(72) Inventor: Moroi, Masayuki, Tsuchiura-Shi Ibaraki-Prefecture 300 (JP)
(74) Representative: Abbott, David John

(56) References cited:
- EP-A- 0 253 162
- EP-A- 0 260 128
- US-A- 4 648 588
- US-A- 4 720 130
- US-A- 4 763 941

## Description

### FIELD OF THE INVENTION

This invention relates to continuous chemical vapor deposition reactors, and more particularly to improvements in semiconductor wafer pick-up devices for use with such reactors.

### BACKGROUND OF THE INVENTION

A continuous chemical deposition reactor may be a stand-alone process system with a continuous semiconductor wafer flow. Basic subsystems in such a system may include a wafer handling system, a reaction chamber, a gas flow system, a cooling system, and an electrical system.

The wafer handling system may include wafer loaders and unloaders, wafer carriers, and a track for moving a wafer through the reactor chambers. The semiconductor wafers are orientated to a known position so that pick-up devices may properly place the wafer in a carrier, which is indexed through the reactor system.

A basic reactor and process may be as follows. A semiconductor wafer is first picked-up by a wafer handing device. The wafer is then oriented prior to be loading onto a carrier which enters one end of the reactor through a port and is moved successively through the various chambers and out the other end of the reactor through another port.

Each semiconductor wafer is a round disk with a flat edge thereon, the flat edge being used to permit orientation of the wafer for placement in a carrier prior to transporting the wafer through the process reactor.

The reactor may not be physically closed, but has gas seals at each end and in between each chamber of the reactor. As an example, a reactor may include eight chambers in which the first chamber consists of a nitrogen seal, the second chamber is a preheat chamber, the next four chambers may be deposition chambers, then a cool-down chamber and the last chamber is a nitrogen seal.

A typical gas supply system may supply gases for two different deposition processes which may be directed into any of the deposition chambers.

Each chamber is effectively divided into two portions, a top portion and a bottom portion by the substrate carrier. The junctions between the chambers effectively isolate one chamber from the other by the flow of gases, or the exhaust gases from the chambers.

US-A-4 648 588 discloses an apparatus for picking up thin planar objects by suction applied down a hollow support arm pivotally attached to a base member, there being a flat, flexible sealing disc surrounding the suction orifice at the end of the arm.

In EP-A-0 260 128 there is disclosed a suction device for handling articles, the device having a porous plate under a vacuum chamber with the open-cell sponge material disposed between the plate and the article to be picked up. A projecting sealing strip is provided around the periphery of the porous plate and the sponge material to seal the device to the surface of the article.

The suction device is elastically coupled via a coil spring to a frame mounted to the arm of an article handling machine.

### SUMMARY OF THE INVENTION

According to the present invention there is provided a pick-up device for moving a semiconductor wafer as given in claim 1.

A device according to the invention may be used for moving an oriented semiconductor wafer for placement in a semiconductor carrier which may be used in, for example, a multi-chamber continuous chemical vapor deposition reactor and subsystems therein through which substrates may be passed in order to perform etching and various deposition processes thereon. A semiconductor wafer is removed from a wafer cassette by a robotic arm which has a pick-up device which picks up the wafer from the non-process side of the wafer without using the edge of the wafer, thus removing the tendency to stress, and eliminating the need for dimensional accuracy in the picker. The picker travels freely up and down and does not have to initially engage the surface of the wafer in a parallel orientation to eliminate stress or pressure being applied to the wafer. Tapered posts are used so that the picker mechanism seats in the same place or location each time a wafer is picked up and is placed in a carrier.

Prior to placement in the carrier, the wafer must be centered and oriented so that the wafer may be placed in the carrier without breaking the wafer. In this respect, since the wafer is generally round with a flat reference edge, the flat edge must be in a known position so that it may correspond to the flat orientation position in the carrier. To accomplish wafer orientation, the wafer is placed on a centering mechanism that has several tapered posts. At least one of the tapered posts is turned to rotate the wafer until the flat orientation flat on the wafer is positioned over an optical sensor. The tapered post centers the wafer and the optical sensor locates the orientation flat so that wafer may be picked up centered on the picker, and placed in the wafer carrier with the orientation flat on the wafer matching the flat on the carrier.

The surface of the pick-up device is coated with a material that will not scratch the semiconductor wafer, for example, a high molecular weight polyethylene material such as those known by trade names as TEFLON and DELRIN.

The technical advance represented by the invention as well as the objects thereof will become apparent from the following description of a preferred embodiment of the invention when considered in conjunction with the accompanying drawings, and the novel features set forth in the appended claims.

### BRIEF DESCRIPTION OF THE DRAWINGS

Figure 1 illustrates a typical continuous chemical vapor deposition reactor in which the invention may be used;
Figure 2 illustrates an example of a semiconductor carrier with an orientation flat;
Figure 3 illustrates a semiconductor picker of the present invention;
Figure 4 illustrates the semiconductor picker of Figure 3 in another position;
Figure 5 illustrates a top view of the semiconductor wafer centering and orientation mechanism;
Figure 6 is a side view of the centering and orientation mechanism of Figure 5;
Figure 7 is a side view in section of the centering and orientation mechanism of Figure 5; and
Figure 8 illustrates a centered and orientated semiconductor wafer.

### DESCRIPTION OF A PREFERRED EMBODIMENT OF THE INVENTION

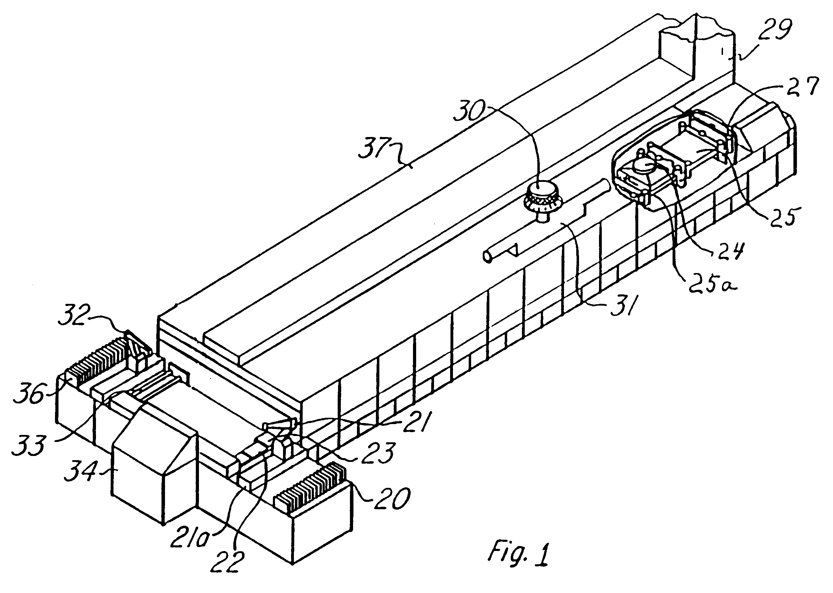

Figure 1 illustrates a typical reactor utilizing the present invention. A plurality of wafer cassettes 20̸ are located along and adjacent to a robotic arm 21 which moves along a track 21a. The track allows the robotic arm 21 to move adjacent to each of a plurality of wafer cassettes so as to permit the robotic arm to access each wafer in each cassette. The robotic arm lifts a wafer from a cassette and places it in a carrier 22 at the entrance to the reactor. The entrance 23 to the reactor is a seal joint to prevent gases in the reactor from exiting from the reactor.

At the entrance 23, and before the carrier enters the reactor a vacuum pick-up arm (not illustrated) lifts the lid from the carrier to allow the robotic arm to place a semiconductor wafer into the carrier. After the semiconductor is placed into the carrier the carrier lid is replaced and the carrier is indexed through the reactor and the plurality of chambers that make up the reactor.

The carrier is indexed through the reactor and chambers using the length of the carrier and at least one spacer bar between each carrier. As each carrier is indexed into the reactor, each preceding carrier is moved to the next reactor chamber.

The indexing is continuous, and as the carrier exits from the last reaction chamber it is indexed through the return path of the reactor to the exit opening in the reactor, where the lid of the carrier is removed by the return lid pick-up (not illustrated). Tracks 33, which extend through out the reactor, are used to move the wafer carrier through the reactor. A robotic arm 32 mounded on track 32a removes the semiconductor wafer from the carrier and places it in a wafer cassette 36.

The reactor is divided into a plurality of quartz reactor chambers 25. The reaction chambers 25 are joined by a junction 25a through which is introduced the process gases and from which the used gases are exhausted.

Positioned over each reaction chamber is a heater block 24, used to heat the reaction chamber to a desired temperature. Water to cool the lamp housing is introduced through the junctions 25a though inlet 26.

Each junction 25a has at least one exhaust tube 27 for removing exhaust gases from the reaction chambers. The exhaust gases are directed through a burn-off tube 31 to the gas burner 30̸.

The entire reactor is shrouded in an enclosure 37, and an air duct 29 is provided to circulate and exhaust gas/air from inside the system shroud.

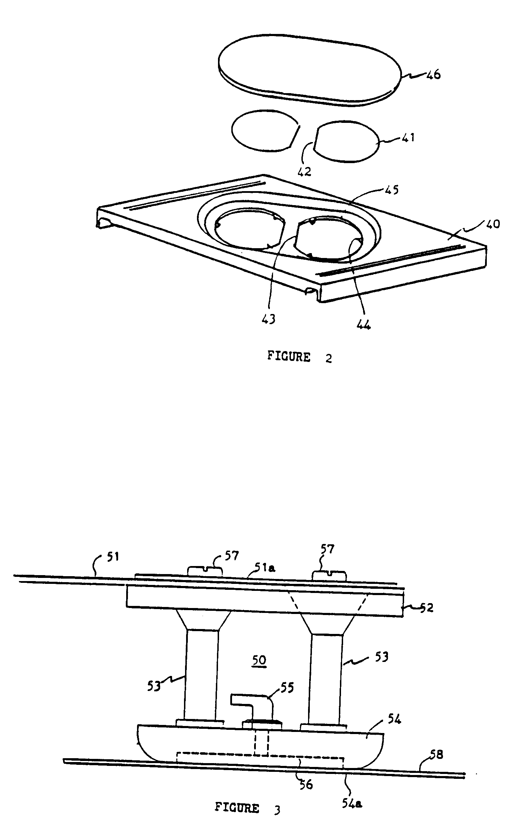

Figure 2 illustrates a semiconductor carrier 40̸ having an opening 45 therein into which is placed a semiconductor wafer 45. The wafer has one flat edge 42 which is used to index or orientate the wafer. Opening 45 also has a flat side 43 to match the flat edge 42 of the semiconductor wafer. Tabs 44 protrude from the bottom of opening 45 to hold the semiconductor in the opening and to expose a maximum of the under side of the wafer, which is the process side of the wafer. A lid is used to cover the up or back side of the wafer during processing.

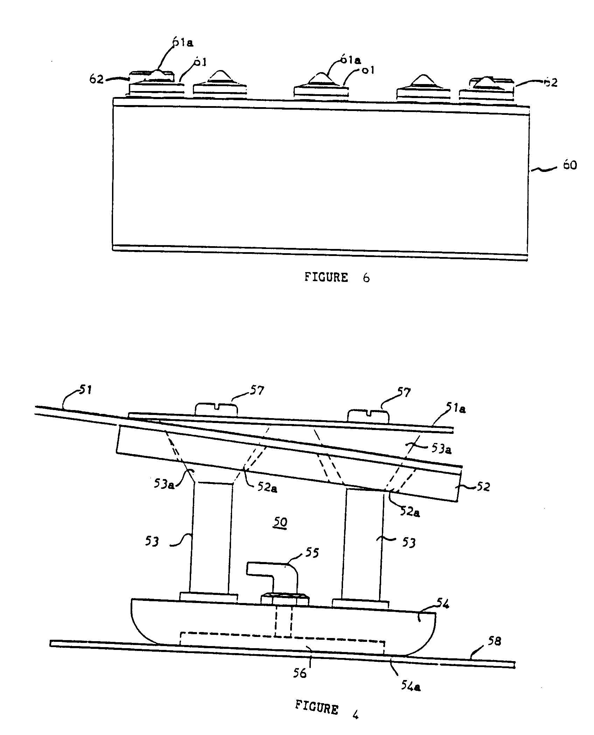

Figure 3 illustrates the pick-up device used on the end of a robotic arm to move the semiconductor wafer to be processed to a centering and orientating device. The device 50̸ is movably mounted on an extension of the robotic arm 51,52, part 52 being a positioning block in which tapered holes 52a are used to position the conical parts 53a of posts 53. Pick-up device 50̸ includes two posts 53, each having one end tapered in a generally conical shape. The two posts 53 are mounted between upper plate 51a and low pick-up head 54. Plate 51 is secured to post 53 by screws 57. The post may be either bonded to or secured to pick-up head 54 by threaded holes (not shown).

Pick-up device 50̸ has a fitting 55 mounted thereon which attaches to a vacuum source (not illustrated) and opens into vacuum cavity 56 in the bottom surface of pick-up head 54. When pick-up head 54 is lowered into contact with a semiconductor device 58 with a vacuum applied, semiconductor wafer 58 will be drawn up against the bottom surface 54a of pick-up head 54 and held there until the vacuum is removed or released. While the semiconductor device is held against the bottom surface of the pick-up device it may be moved, for example from a loading surface/cassette to the centering and orientating mechanism described below.

Figure 4 illustrates the picking-up of a wafer without placing stress on the wafer, allowing a vacuum to be drawn against the wafer thereby allowing the wafer to be picked up. In prior art reactor systems, the semiconductor wafer is usually processed face up so that the wafer has to be picked up by the edge and not by a face of the wafer.

Using the device of the present invention, when robotic arm is lowered to pick-up a semiconductor wafer, the bottom surface of the pick- up head comes into contact with the bottom or non-process surface of semiconductor wafer 58. Since the robotic arm is being angled down, the bottom surface 54a does not move parallel into engagement with the surface of the semiconductor wafer. To avoid applying excessive pressure on the surface of the semiconductor wafer, and to permit the entire bottom surface 54a to come into contact with the semiconductor wafer surface, posts 53 are not secured to arm 51 and part 52.

The tapered ends 53a of posts 53 reside in tapered holes 52 in robotic arm parts 51 and 52 so that when the arm 51 is lowerea and surface 54a comes into contact with the surface of the semiconductor wafer, arm 51 may continue downward a short distant without additional pressure against the semiconductor wafer.

The movement of pick-up device 50̸ is essentially independent of the movement of arm 51 permitting the lower surface 54a to continue to move so that it becomes parallel to the surface of the semiconductor wafer, thereby permitting a vacuum to be drawn in vacuum cavity 56, holding and securing the semiconductor wafer to the bottom of the pick-up head.

When arm 51 is raised, the tapered part 53a of post 53 positions the pick-up device to a fixed and known position at the end of robotic arm 51, and therefore positions the semiconductor to a known position. This precise positioning of the pick-up device is important in later proper orientation of the semiconductor wafer.

The pick-up device has been shown with two tapered posts 53, however, a single post may be used or, for example three posts may be used. As long as the posts are tapered, the accurate positioning will take place.

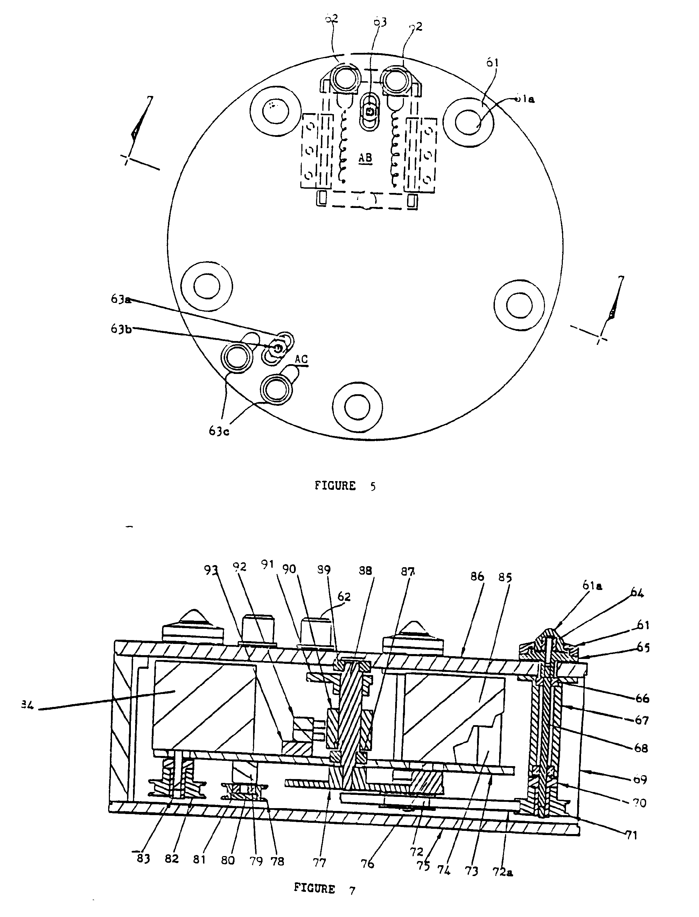

Figures 5, 6 and 7 illustrate a device used in conjunction with the pickup device for centering a semiconductor wafer and finding the flat edge of the wafer. Figure 5 is the top view of the centering and orientation device 60̸. There are five rollers having a top roller 61a and a wafer orientation roller 61. There are four rollers 62 that engage the flat side of the wafer and two fiber optic cables 63.

A semiconductor wafer is placed down over the rollers 61,61a such that the edges of the wafer will slide down the tapered surface of top roller 61a and come to rest on the surface of orientation roller 61. When the rollers 61,61a are rotated, the semiconductor wafer will become centered, and rotation will continue until the flat edge of the semiconductor exposes the end of fiber optic light detector 63. At this time rotation of rollers 61, 61a stops and rollers 62 engage the flat side of the wafer.

Rollers 62 are spring loaded so that as the wafer rotates, the round edge of the wafer engages the rollers in a position toward the edge of the device 60̸, however when the flat part of the device rotates around to the location of the rollers 62, they will be drawn to the flat edge by springs. Rollers 62 move back and forth in slots. Light impinging on the end of the fiber optic indicates that the flat edge of the wafer is in the vicinity of the fiber optics 63 and the flat edge rollers 62.

Figure 6 is a side view of orientation device 60̸ showing the tapered surfaces of rollers 61 and 61a, and the vertical sides of rollers 62.

Figure 7 is cross-sectional view taken through section 7-7 of Figure 5. Centering orientation device 60̸ has an outer cover 69, a top base plate 86 and a bottom base plate 75. The mechanism for rotating rollers 61 and 61a is shown in detail at the right side of Figure 7. Rollers are mounted on the top end of shaft 68, which is mounted in top and bottom bearings 66. The rollers are mounted at the end of shaft 68 and ride on roller table 65. A pulley 71 is mounted on the bottom end of shaft 68 on bushing 70̸. Shaft 68 is rotated by motor/gear combination 85,76. Gear 76 rotates pulley 72 which drives timing belt 72a, which drives pulley 71 on shaft 68.

Motor 85 also turns drive shaft 88 via gear 77. Drive shaft is mounted in bearings 87 and 88.

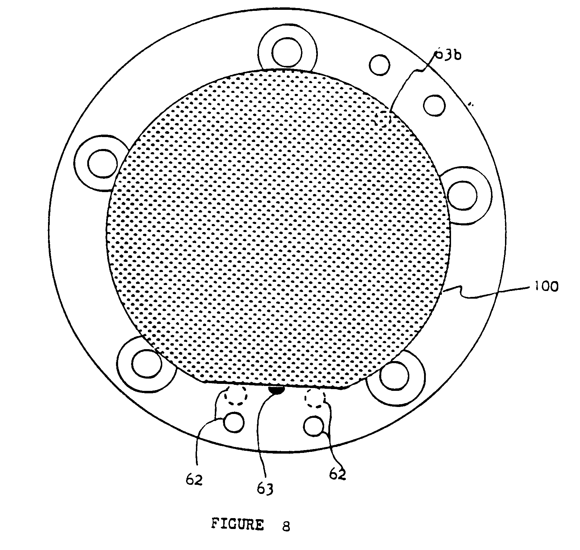

A wafer is lowered onto rollers 61 as shown in Figure 5 and Figure 8. The wafer is rotated by motor 84, drive shaft 83 and pulleys 71 and 82, with drive belt 72a. A preliminary location for the flat on the wafer is found by light sensor 63 in locator assembly AC and stops drive motor 84. The final location for the flat on the semiconductor wafer is determined when drive motor 85 turns gears 66 and 67, which in turn rotate cam 91, releasing flat finder 62 . Springs pull the flat finder 62 toward the center of the centering device causing the wafer to be correctly oriented. At the same time rollers 61a rotate freely, thereby reducing friction and allowing a long or short rotation time as required to orientate the wafer. Once the wafer is orientated, the robotic pick-up device illustrated in Figures 3 and 4 can pickup the semiconductor wafer and place it in a wafer carrier.

Figure 8 shows a semiconductor wafer 100 supported by rollers 61 and centered between the rollers 61a. Rollers 62 are illustrated in the extended position in solid lines and retracted positions in dashed lines. Fiber optic end is shown at 63 at the lfat edge of the wafer. The end of the fiber optic is shown in dashed lines, under the wafer at the second optical fiber location 63b. The pick-up device of Figures 3 and 4 picks-up the semiconductor device 100 and places it in the carrier 40 illustrated in Figure 2.

## Claims

1. A pick-up device (50) for moving a semiconductor wafer (58), the pick-up device being movably mounted on a mechanical or robotic arm extension (51,52), the pick-up device comprising an upper plate (51a), a lower pick-up head (54), with a vacuum cavity (56) residing therein and opening to its underside, and at least one mounting post (53), the at least one mounting post having upper and lower ends, the upper end (53a) being conically shaped, and securely attached to said upper plate, the lower end being securely attached to said lower pick-up head, the at least one mounting post being further movably attached to the robotic arm extension (51,53) through a corresponding tapered hole (52a) in the robotic arm extension and being removable therefrom during the picking-up of a semiconductor wafer, the at least one mounting post serving to hold the lower pick-up head parallel to the robotic arm extension while the robotic arm extension is supporting the lower pick-up head, and permitting an upward force on the lower pick-up head due to engagement with semiconductor wafer to position the lower pick-up head parallel to the semiconductor wafer independently of the orientation of the robotic arm extension with respect to the semiconductor wafer.

2. A pick-up device according to claim 1, wherein there are two posts (53) both of which are conically shaped at the upper end (53a) and fit into two round tapered holes (52a) in the robotic arm extension (51,52).

3. A pick-up device according to claim 1 or claim 2, wherein the lower pick-up head (54) is of a high molecular weight polyethylene material that will not scratch the semiconductor wafer when the semiconductor wafer is held thereagainst during movement.

4. A pick-up device according to any one of claim 1, 2 and 3, wherein the pick-up head (54) has a top surface and a bottom surface parallel to each other and the vacuum cavity (56) has a connection (55) through the top surface of the pick-up head through which the vacuum is applied.

5. A pick-up device according to claim 4, wherein the vacuum cavity opening comprises the greatest part of the bottom surface of the pick-up head (54), the remaining part of the bottom of the pick-up head extending in an arc (54a) from the edge of the vacuum cavity opening to the top surface of the pick-up head.

6. A wafer handling system consisting of a pick-up device according to any of the preceding claims and a device for centering and orientating a semiconductor wafer having an orientation flat on one edge, said device for centering and orientating comprising:
a housing (69);
a plurality of tapered rollers (61,61a) arranged around the periphery of a plate above the housing and rotatable about respective vertical axes;
at least one drive motor (84) for rotating the tapered rollers; and
a photo cell (63) for detecting the orientation flat edge on the semiconductor wafer for allowing the pick-up device (50) to pick up a semiconductor wafer with a predetermined orientation from said device for centering and orientating.

7. A system according to claim 6 wherein the centering and orientating device includes a pair of flat finder rollers (62) which press against the flat edge of a semiconductor wafer when that flat edge is adjacent to the photo cell (63) and the flat finder rollers (62).

8. A system according to claim 7 wherein the centering and orientating device includes a cam (91) and a second drive motor (85) for turning said cam, said cam and second drive motor allowing the flat finder rollers (62) to be pressed against the flat edge of the semiconductor wafer when the photo cell (63) detects a flat on the semiconductor wafer.

## Patentansprüche

1. Aufnehmervorrichtung (50) zum Bewegen eines Halbleiterplättchens (58), wobei die Aufnehmervorrichtung an einem mechanischen Armfortsatz oder einem Roboterarmfortsatz (51, 52) beweglich angebracht ist und eine obere Platte (51a), einen unteren Aufnehmerkopf (54) mit einer darin befindlichen und sich zu seiner Unterseite hin öffnenden Unterdruckausnehmung (56) sowie wenigstens eine Haltestütze mit oberen und unteren Enden aufweist, wobei das obere Ende (53a) konisch geformt und fest an der oberen Platte befestigt ist, während das untere Ende an dem unteren Aufnehmerkopf befestigt ist, wobei die wenigstens eine Haltestütze ferner beweglich an dem Roboterarmfortsatz (51, 53) über ein entsprechendes konisches Loch (52a) in dem Roboterarmfortsatz befestigt und von diesem während des Aufnehmens eines Halbleiterplättchens entfernbar ist, wobei die wenigstens eine Haltestütze dazu dient, den unteren Aufnehmerkopf parallel zu dem Roboterarmfortsatz zu halten, während der Roboterarmfortsatz den unteren Aufnehmerkopf hält und eine nach oben gerichtete Kraft auf den Aufnehmerkopf aufgrund einer Einwirkung auf das Halbleiterplättchen zuzulassen, damit der untere Aufnehmerkopf unabhängig von der Lage des Roboterarmfortsatzes bezüglich des Halbleiterplättchens parallel zum Halbleiterplättchen gehalten wird.

2. Aufnehmervorrichtung nach Anspruch 1, bei welcher zwei Stützen (53) vorhanden sind, die beide am oberen Ende (53a) konisch geformt sind und in zwei runde, konische Löcher (52a) im Roboterarmfortsatz (51, 52) passen.

3. Aufnehmervorrichtung nach Anspruch 1 oder 2, bei welcher der untere Aufnehmerkopf (54) aus einem Polyethylenmaterial mit hohem Molekulargewicht besteht, das das Halbleiterplättchen nicht verkratzt, wenn das Halbleiterplättchen während der Bewegung gegen ihn gehalten ist.

4. Aufnehmervorrichtung nach einem der Ansprüche 1, 2 und 3, bei welcher der Aufnehmerkopf (54) eine obere Fläche und eine dazu parallele untere Fläche aufweist und die Unterdruckausnehmung (56) eine Verbindung (55) durch die obere Fläche des Aufnehmerkopfes hindurch aufweist, durch die der Unterdruck angelegt wird.

5. Aufnehmervorrichtung nach Anspruch 4, bei welcher die Öffnung der Unterdruckausnehmung den größten Teil der unteren Fläche des Aufnehmerkopfes (54) einnimmt, wobei der übrige Teil der Unterfläche des Aufnehmerkopfes in einem Bogen (54a) vom Rand der Öffnung der Unterdruckausnehmung zur oberen Fläche des Aufnehmerkopfes verläuft.

6. Plättchenbehandlungssystem, bestehend aus einer Aufnehmervorrichtung gemäß einem der vorhergehenden Ansprüche und einer Vorrichtung zum Zentrieren und Ausrichten eines Halbleiterplättchens mit einer Ausrichtabflachung an einem Rand, wobei die Vorrichtung zum Zentrieren und Ausrichten folgendes enthält:
ein Gehäuse (69);
mehrere konische Rollen (61, 61a), die rund um den Umfang einer Platte über dem Gehäuse und um jeweilige vertikale Achsen drehbar angeordnet sind;
wenigstens einen Antriebsmotor (84) zum Drehen der konischen Rollen;
eine Photozelle (63) zum Auffinden des mit der Ausrichtabflachung versehenen Randes des Halbleiterplättchens, damit die Aufnehmervorrichtung (50) das Halbleiterplättchen mit einer vorbestimmten Ausrichtung von der Vorrichtung zum Zentrieren und Ausrichten aufgenommen werden kann.

7. System nach Anspruch 6, bei welchem die Zentrier- und Ausrichtvorrichtung zwei Abflachungs-Auffindrollen (62) enthält, die gegen den Abflachungsrand eines Halbleiterplättchens drücken, wenn der Abflachungsrand der Photozelle (63) und den Abflachungs-Auffindrollen (62) benachbart liegt.

8. System nach Anspruch 7, bei welchem die Zentrier- und Ausrichtvorrichtung einen Kurvenkörper (91) und einen zweiten Antriebsmotor (85) zum Drehen des Kurvenkörpers enthält, wobei der Kurvenkörper und der zweite Antriebsmotor den Abflachungs- Auffindrollen (62) ermöglichen, gegen den Abflachungsrand des Halbleiterplättchens gedrückt zu werden, wenn die Photozelle (63) eine Abflachung am Halbleiterplättchen feststellt.

## Revendications

1. Dispositif de ramassage (50) pour déplacer une pastille de semi-conducteur (58), le dispositif de ramassage étant monté de façon déplaçable sur un prolongement de bras mécanique ou automatique (51, 52), le dispositif de ramassage comprenant un plateau supérieur (51a), une tête de ramassage inférieure (54) munie d'une cavité à vide (56) et d'une ouverture dans sa surface inférieure et au moins un support de montage (53), le au-moins un support de montage comportant des extrémités supérieure et inférieure, l'extrémité supérieure (53) étant de forme cônique et attachée de façon fixe audit plateau supérieur, l'extrémité inférieure étant attachée de façon fixe à ladite tête de ramassage inférieure, le au moins un support de montage étant de plus attaché de façon déplaçable audit prolongement de bras automatique (51, 53) par l'intermédiaire d'un trou cônique correspondant (52a), dans le prolongement de bras automatique et pouvant être enlevé de celui-ci durant le ramassage d'une pastille de semi-conducteur, le au moins un support de montage servant à maintenir la tête de ramassage inférieure parallèle au prolongement de bras automatique lorsque le prolongement de bras automatique supporte la tête de ramassage inférieure, et permettant d'exercer une force dirigée vers le haut sur la tête de ramassage inférieure dûe à l'engagement avec la pastille de semiconducteur pour positionner la tête de ramassage inférieure parallèle à la pastille de semi-conducteur indépendamment de l'orientation du prolongement de bras automatique par rapport à la pastille de semi-conducteur.

2. Dispositif de ramassage selon la revendication 1, dans lequel sont prévus deux supports (53) tous deux de forme cônique à l'extrémité supérieure (53a) et s'adaptant dans deux trous de forme circulaire (52a) du prolongement de bras automatique (51, 52).

3. Dispositif de ramassage selon l'une des revendications 1 et 2, dans lequel la tête de ramassage inférieure (54) est constituée d'un matériau en polyéthylène de poids moléculaire élevé qui ne raye pas la pastille de semi-conducteur lorsqu'elle est maintenue en contact avec la pastille de semi-conducteur durant le mouvement.

4. Dispositif de ramassage selon l'une quelconque des revendications 1, 2 et 3, dans lequel la tête de ramassage (54) comporte une surface supérieure et une surface inférieure mutuellement parallèles et dans lequel la cavité à vide (56) comporte une connexion (55) dans la surface supérieure de la tête de ramassage dans laquelle le vide est appliqué.

5. Système de ramassage selon la revendication 4, dans lequel l'ouverture de la cavité à vide comporte en grande partie la surface inférieure de la tête de ramassage (54), la partie restante de la partie inférieure de la tête de ramassage s'étendant dans un arc (54a) à partir du côté de l'ouverture de la cavité à vide vers la surface supérieure de la tête de ramassage.

6. Dispositif de maintien d'une pastille comportant un dispositif de ramassage selon l'une quelconque des revendications précédentes et un dispositif pour centrer et orienter une pastille de semi-conducteur ayant un plat d'orientation sur un côté, ledit dispositif pour centrer et orienter comprenant:
- un boîtier (69);
- une pluralité de rouleaux coniques (61, 61a) disposés autour de la périphérie d'un plan au-dessus du boîtier et monté à rotation par rapport à des axes verticaux respectifs;
- au moins un moteur d'entraînement (84) pour entraîner en rotation les rouleaux coniques; et
- une cellule photoélectrique (63) pour détecter le côté plat d'orientation sur la pastille de semiconducteur pour permettre au dispositif de ramassage (50) de ramasser la pastille de semi-conducteur avec une orientation prédéterminée par rapport audit dispositif pour centrer et orienter.

7. Système selon la revendication 6 dans lequel le dispositif pour centrer et orienter comporte une paire de rouleaux de repères plats (62) qui appuient contre le côté plat d'une pastille de semi-conducteur lorsque ce côté plat est adjacent à la cellule photoélectrique (63) et aux rouleaux de repères plats (62).

8. Système selon la revendication 7 dans lequel le dispositif pour centrer et orienter comporte une came (91) et un second moteur d'entraînement (85) pour entraîner ladite came et le second moteur d'entraînement permettant au rouleau de repères plats (62) d'appuyer contre le côté plat de la pastille de semi-conducteur lorsque la cellule photoélectrique (63) détecte un plat sur la pastille de semi-conducteur.
